(19) Europäisches Patentamt

European Patent Office

Office européen des brevets

(11) EP 0 792 546 B1

(12) **EUROPÄISCHE PATENTSCHRIFT**

(45) Veröffentlichungstag und Bekanntmachung des Hinweises auf die Patenterteilung:
**28.07.1999 Patentblatt 1999/30**

(21) Anmeldenummer: 95940173.8

(22) Anmeldetag: 14.11.1995

(51) Int Cl.⁶: **H04L 27/01**, H03H 21/00

(86) Internationale Anmeldenummer:
**PCT/EP95/04472**

(87) Internationale Veröffentlichungsnummer:
**WO 96/16495 (30.05.1996 Gazette 1996/25)**

(54) **VERFAHREN UND ANORDNUNG ZUM ENTZERREN VON ZWEI DATENSTRÖMEN**

DISTORTION CORRECTOR FOR TWO DATA FLOWS AND CORRESPONDING METHOD

PROCEDE ET DISPOSITIF DE CORRECTION DES DISTORSIONS DE DEUX FLUX DE DONNEES

(84) Benannte Vertragsstaaten:
**DE ES FR GB IT**

(30) Priorität: **17.11.1994 DE 4440964**

(43) Veröffentlichungstag der Anmeldung:
**03.09.1997 Patentblatt 1997/36**

(73) Patentinhaber: **DEUTSCHE THOMSON-BRANDT GMBH**
**78048 Villingen-Schwenningen (DE)**

(72) Erfinder:
- **SCHÖPS, Gerhard, Hans, Herbert**
  **D-80687 München (DE)**
- **DINSEL, Siegfried**
  **D-80803 München (DE)**

(74) Vertreter: **Hartnack, Wolfgang, Dipl.-Ing. et al**
**Deutsche Thomson-Brandt GmbH**
**Licensing & Intellectual Property,**
**Karl-Wiechert-Alee 74**
**30625 Hannover (DE)**

(56) Entgegenhaltungen:
**EP-A- 0 106 136**

- **IEEE PACIFIC RIM CONF. ON COMMUNIC. COMP. AND SIGNAL PROCESSING;VICTORIA (CA); P482- 486; W.E.MATTIS: A HYBRID FRACTIONALLY SPACED DIGITALLY CONTROLLED EQUALIZER ... XP000077526**

**Beschreibung**

Die Erfindung betrifft ein Verfahren und eine Vorrichtung zum Entzerren von Datenströmen.

Stand der Technik

Bei der Übertragung digitaler modulierter Nachrichtensignale treten auf dem Übertragungsweg bis zum Empfänger lineare Verzerrungen, insbesondere Echos auf. Da sich die Echos zeitlich ändern können, muß eine Entzerrung adaptiv erfolgen. Ferner können Verzerrungen innerhalb des Empfängers im Demodulationspfad auftreten, welche bei einer Entzerrung berücksichtigt werden müssen. Aus der EP-B-O 179 393 ist es bekannt, zur Entzerrung ein Oberflächenwellenfilter zu verwenden, dessen Koeffizienten adaptiv einstellbar sind. Das Oberflächenwellenfilter wird vor dem Demodulationspfad angeordnet. Zur Berechnung der Koeffizienten wird dafür üblicherweise das verzerrte trägerfrequente Signal vor dem Oberflächenwellenfilter mit dem entzerrten, trägerfrequenten Signal nach dem Oberflächenwellenfilter verglichen. Eine Erfassung der Verzerrungen im Demodulationspfad ist damit nicht möglich.

IEEE Pacific Rim Conference on Communications, Computers and Signal Processing, 1.-2. Juni 1989, Villanova PA; Seiten 482-486 (W.E. Mattis) und EP-A-0 106 136 beschreiben ein Verfahren zum Entzerren von zwei quadraturmodulierten Datenströmen mit einem steuerbaren, nicht-rekursivem Filter, welches im Signalweg vor einem Demodulator für die Datenströme angeordnet ist und dessen Koeffizienten mittels der demodulierten Datenströme gesteuert werden. Es werden jedoch zwei Demodulatoren benötigt, einer für das Entzerren des Signals und einer für die Einstellung der Koeffizienten des Entzerrers.

Erfindung

Der Erfindung liegt die Aufgabe zugrunde, ein Verfahren anzugeben, bei dem die im Übertragungsweg und im Empfänger auftretenden Signalstörungen mittels einer verbesserten Steuerung der Filterkoeffizienten entzerrt werden. Diese Aufgabe wird durch die in den Ansprüchen 1 und 2 angegebenen Verfahren gelöst.

Der Erfindung liegt die weitere Aufgabe zugrunde, Vorrichtungen zur Anwendung der erfindungsgemäßen Verfahren anzugeben. Diese Aufgabe wird durch die in den Ansprüchen 3 und 4 angegebenen Vorrichtungen gelöst.

Zeichnungen

Die Erfindung wird anhand der Zeichnungen näher erläutert. Es zeigen:

Fig. 1-4   Blockschaltbilder von Ausführungsbeispielen der erfindungsgemäßen Entzerreranordnung;

Fig. 5   Blockschaltbild eines für die Anordnungen nach Fig. 1 bis 4 geeigneten Filters.

Ausführungs-Beispiele

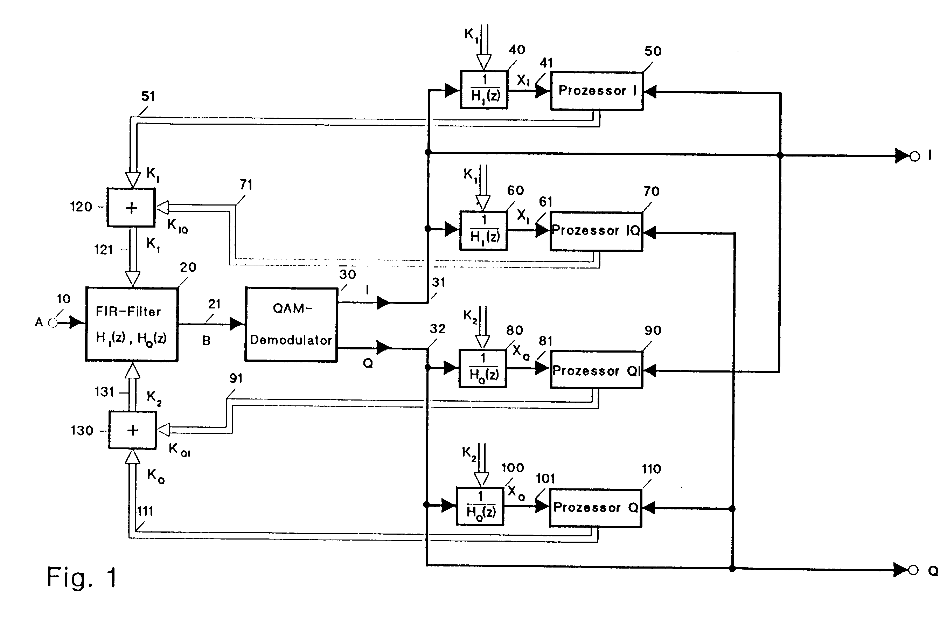

Fig. 1 zeigt eine Anordnung, bestehend aus einem nicht-rekursiven FIR-Filter 20 mit den beiden Teilübertragungsfunktionen $H_I(z)$ und $H_Q(z)$, einem Quadraturamplitudendemodulator 30, einer Addierschaltung 120, einer Addierschaltung 130, einer Schaltung 40 zur Umwandlung des Datenstroms I mit der inversen Filterübertragungsfunktion $1/H_I(z)$, einer Schaltung 60 zur Umwandlung des Datenstroms I mit ebenfalls der inversen Filterübertragungsfunktion $1/B_I(z)$, einer Schaltung 80 zur Umwandlung des Datenstroms Q mit der inversen Filterübertragungsfunktion $1/H_Q(z)$, einer Schaltung 100 ebenfalls zur Umwandlung des Datenstroms Q mit der inversen Filterübertragungsfunktion $1/H_Q(z)$, einem Prozessor I 50 für die I-Komponente, einem Prozessor IQ 70 für die IQ-Komponente, einem Prozessor QI 90 für die QI-Komponente und einem Prozessor Q 110 für die Q-Komponente des Basisbandsignals.

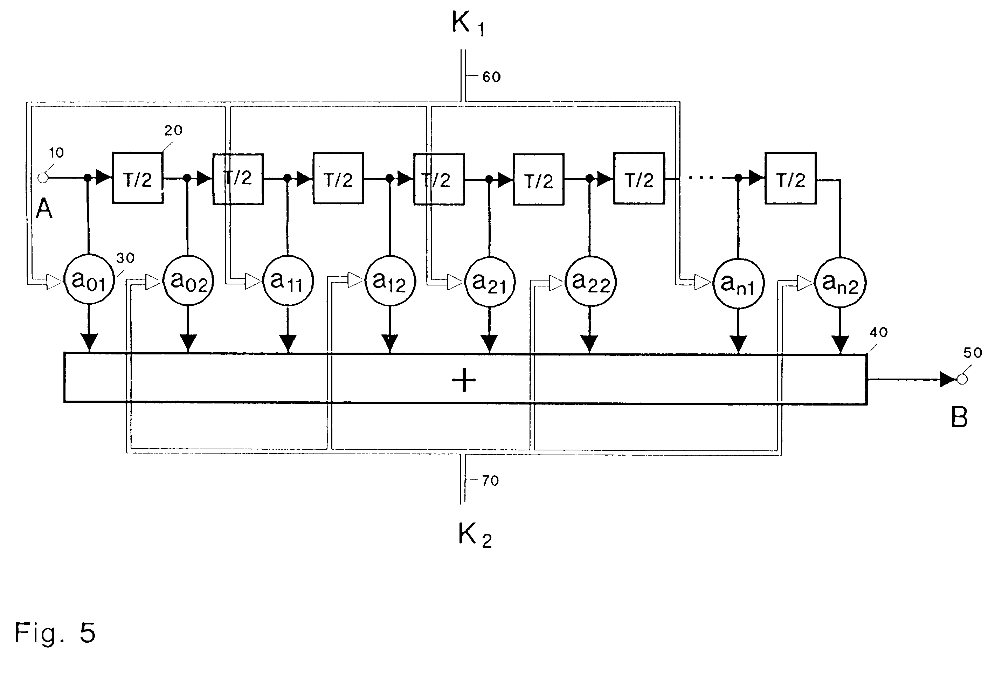

Das Eingangssignal A 10 ist ein linear verzerrtes, insbesondere echoverzerrtes, quadraturamplitudenmoduliertes Signal im Trägerfrequenzbereich. Dieses Signal 10 ist das Eingangssignal eines einstellbaren nicht-rekursiven FIR-Filters 20 (Final Impulse Response, Transversalfilter), welches die Struktur nach Fig. 5 aufweist. Das gefilterte Ausgangssignal B 21 dieses einstellbaren nicht-rekursiven FIR-Filters 20 ist das Eingangssignal eines Quadraturamplituden-Demodulators 30, indem sich die beiden um jeweils 90 Grad zueinander phasenverschobenen Ausgangssignale I 31 und Q 32 durch Aufspalten des Eingangssignals und Multiplizieren des eines Anteils mit dem Trägersignal $\sin(w_T t)$ und Multiplizieren des anderen Anteils mit dem Trägersignal $\sin(w_T t + T/2)$ ergeben. Dabei ist Zeitkonstante T der zeitliche Abstand zwischen zwei unmittelbar benachbarten Symbolen des demodulierten Signals. Das eine Ausgangssignal I 31 des QAM-Demodulators ist das Eingangssignal in eine Schaltung 40 zur Umwandlung des Datenstroms I mit der inversen Filterübertragungsfunktion $1/H_I(z)$, einer Schaltung 60 zur Umwandlung des Datenstroms I mit der inversen Filterübertragungsfunktion $1/H_I(z)$ und zugleich das Ausgangssignal I der Anordnung. Das Teilsignal Q 32 ist das Eingangssignal in eine Schaltung 80 zur Umwandlung des Datenstroms I mit der inversen Filterübertragungsfunktion $1/H_Q(z)$, eine Schaltung 100 zur Umwandlung des Datenstroms Q mit der inversen Filterübertragungsfunktion $1/H_Q(z)$ und zugleich das Ausgangssignal Q der Anordnung. Die Schaltungen 40, 60, 80, 100 zur Umwandlung des Datenstromes I und Q mit der inversen Filterübertragungsfunktion $1/H_I(z)$ und $1/H_Q(z)$ gleichen den Umstand aus, daß das nicht-rekursive FIR-Filter 20 vor der Demodulation angeordnet ist und das linear verzerrte Eingangssignal A 10 der Anordnung nicht direkt das Basisbandeingangssignal in den jeweiligen Prozessor I 50, IQ 70, QI 90, Q 110 ist. Das nicht-rekursive FIR-Filter 20 vor dem Demodulator kompensiert auch die Demodulatorverzerrungen vor, welche erst nach dem FIR-Filter 20 im Demodulator auftreten. Das Ausgangssignal der Schaltung 40 ensteht durch Faltung des Signals I mit der inversen Filterübertragungsfunktion $1/H_I(z)$. Das Signal $X_I$ 41 und das Signal $X_I$ 61 kann zu den Zeitpunkten t somit aus dem Signal I 31 durch Ausführung der Differenzengleichung in folgender Weise bestimmt werden:

$$X_I(t) = 1/a_{01} \cdot (I(t) - a_{11} \cdot X_I(t-T) - X_I(t-2T) - \ldots - X_I(t-nT)).$$

Die Filterkoeffizienten entsprechen dabei dem Koeffizientensatz $K_1$ zum Zeitpunkt k. Die beiden Signale $X_Q$ 81 und $X_Q$ 101 ergeben sich in gleicher Weise aus dem Signal Q 32, wobei als Koeffizientensatz $K_2$ zum Zeitpunkt k zu nehmen ist. Diese Differenzengleichung stellt ein rekursives IIR-Filter dar und sie kann im jeweilig nachfolgenden Prozessor 50, 70, 90, 110 softwaremäßig realisiert werden, d.h. die Schaltungsteile 40 und 50, 60 und 70, 80 und 90, 100 und 110 können auch als eine schaltungstechnische Einheit betrachtet werden. Das Ausgangssignal $X_I$ 41 der Schaltung zur Umwandlung 40 ist das Eingangssignal in einen Prozessor 50. Der zweite Eingang in diesen Prozessor 50 ist das Ausgangssignal I 31 der Anordnung. Das Eingangssignal $X_I$ 61 des Prozessors 70 ist das Ausgangssignal der Schaltung zur Umwandlung 60 und das zweite Eingangssignal 32 des Prozessors 70 ist das Ausgangssignal Q 32 der Anordnung. Das Ausgangssignal $X_Q$ 81 der Schaltung zur Umwandlung 80 ist das Eingangssignal in einen Prozessor 90. Der zweite Eingang in diesen Prozessor 90 ist das Ausgangssignal I 31 der Anordnung. Das erste Eingangssignal $X_I$ 101 des Prozessors 110 ist das Ausgangssignal der Schaltung zur Umwandlung 100 und das zweite Eingangssignal 32 des Prozessors 110 ist das Ausgangssignal Q 32 der Anordnung. Die Prozessoren 50, 70, 90, 110 errechnen den jeweiligen Koeffizientensatz $K_I$ 51, $K_{IQ}$ 71, $K_{QI}$ 91, $K_Q$ 111 für das FIR-Filter 20 nach Fig. 5, indem sie einen Iterationsalgorithmus ausführen, insbesondere einen bei dem der sich der neue (k+1)-te Koeffizientensatz aus dem k-ten Koeffizientensatz durch Subtraktion eines Korrekturwertes ergibt:

$$a_i(k+1) = a_i(k) - \text{Korrekturwert}.$$

Dieser Korrekturwert wird aus den beiden Eingangssignalen in dem Prozessor gebildet. Als Beispiel für einen solchen Iterationsalgorithmus sei der Least-Mean-Square-Algorithmus mit folgendem mathematischen

Zusammenhang angegeben:

$$a_i^{(k+1)} = a_i^{(k)} - \mu \cdot (y_k - y_r) \cdot x_{k-i},$$

mit dem Koeffizientenindex i, dem Filterkoeffizienten $a_i$, dem Schrittweitenfaktor $\mu$, dem momentanen Filterausgangswert $y_k$, dem Referenzwert $y_r$ und den verzerrten Eingangswerten $x_{k-i}$.

Der berechnete Koeffizientensatz $K_I$ 51 ist das Ausgangssignal des Prozessors I 50. Er wird auf den ersten Eingang einer Addierschaltung 120 geführt. Das zweite Eingangssignal der Addierschaltung 120 ist das Ausgangssignal $K_{IQ}$ 71, der vom Prozessor IQ 70 errechnete Koeffizientensatz. Die Addierschaltung 120 verknüpft jeweils die Anteile mit der gleichen Indexnummer der beiden Koeffizientensätze $K_I$ 51 und $K_{IQ}$ 71 und arbeitet nach folgender Vorschrift:

$$a_{01} = a_{01} + a_{0IQ}, \quad a_{02} = a_{0Q} + a_{0QI},$$

$$a_{11} = a_{1I} + a_{1IQ}, \quad a_{12} = a_{1Q} + a_{1QI},$$

$$a_{21} = a_{2I} + a_{2IQ}, \quad a_{22} = a_{2Q} + a_{2QI}$$

usw.

$$a_{n1} = a_{nI} + a_{nIQ}, \quad a_{n2} = a_{nQ} + a_{nQI}.$$

Das Ausgangssignal $K_I$ 121 ist ein neuer Koeffizientensatz, der den I-Teil der Koeffizienten des FIR-Filters 20 gemäß Fig. 5 steuert und die Teilübertragungsfunktion $H_I(z)$ bildet. Dieses Signal 121 wird auch an die Umwandlungsschaltung 40 geführt. Der andere Q-Teil der Koeffizienten des FIR-Filters 20 ist der in äquivalenter Weise in der Addiersachaltung 130 aus den Koeffizientensätzen $K_{QI}$ 91 und $K_Q$ 111 ermittelte neue Koeffizientensatz K2 131 der die Teilübertragungsfunktion $H_Q(z)$ bildet. Dieses Signal 131 wird auch an die Umwandlungsschaltung 80 geführt.

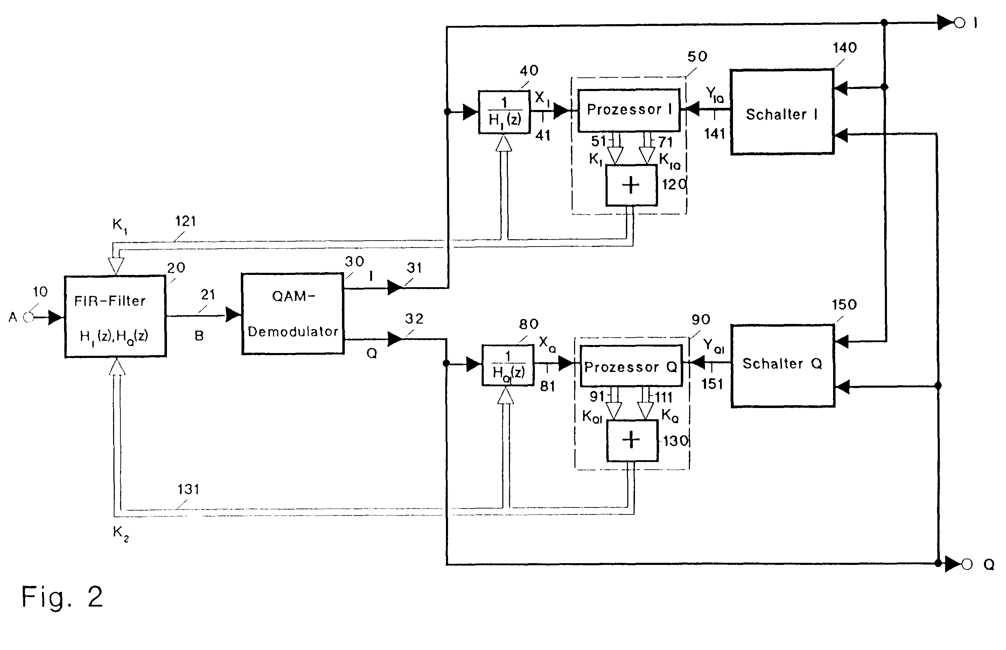

Fig. 2 zeigt eine Anordnung, bestehend aus einem nicht-rekursiven FIR-Filter 20 mit den beiden Teilübertragungsfunktionen $H_I(z)$ und $H_Q(z)$, einem QAM-Demodulator 30, einer Schaltung 40 zur Umwandlung des Datenstroms I mit der inversen Filterübertragungsfunktion $1/H_I(z)$, einer Schaltung 80 zur Umwandlung des Datenstroms Q mit der inversen Filterübertragungsfunktion $1/H_Q(z)$, einem Prozessor I 50 für die I-Komponente, einem Prozessor Q 90 für die Q-Komponente, einem Schalter I 140 zum Durchschalten der Ausgangssignale I 31 und Q 32 der Anordnung auf den zweiten Eingang des Prozessors I 50, einem Schalter I 150 zum Durchschalten der Ausgangssignale I 31 und Q 32 der Anordnung auf den zweiten Eingang des Prozessors Q 90. Der Unterschied von Fig. 2 zu Fig. 1 besteht in einer Vereinfachung derart, daß die Addierschaltungen 120 und 130 von Fig. 1 entfallen und die Koeffizientensätze $K_1$ 121 und $K_2$ 131 in gleicher Weise wie in Fig. 1 schon im jeweiligen Prozessor I 50 bzw. Prozessor Q 90 aufeinander addiert werden. Nach außen hin verhält sich Anordnung von Fig. 2 bezüglich der Signale A 10, I 31 und Q 32 genauso wie die Anordnung von Fig. 1. Desweiteren werden nur zwei Prozessoren I 50 und Q 90, anstatt der in Fig. 1 notwendigen vier Prozessoren I, IQ, QI und Q benötigt und ebenso nur zwei vorgeschaltete Schaltungen 40 und 80 zur Umwandlung des Datenstromes. Die beiden Prozessoren I und Q dieser Fig. 2 arbeiten jeder für sich im Zeitmultiplex den jeweiligen Iterationsalgorithmus für den Eingang I 31 und Q 32 ab. Zusätzlich gegenüber Fig. 1 sind in Fig. 2 ein Schalter I 140 und ein Schalter Q 150 notwendig, deren Eingangssignale das Ausgangssignal I 31 und Q 32 der Anordnung sind. Die Schaltmatrix für den Schalter I 140 kann zum Beispiel lauten:

| Schalterstellung | I | Q | $Y_{IQ}$ |
|---|---|---|---|
| 1 | L | 0 | L |
| 2 | 0 | L | L. |

Die Schaltmatrix für den Schalter Q 150 kann zum Beispiel lauten:

| Schalterstellung | I | Q | $Y_{QI}$ |
|---|---|---|---|
| 1 | 0 | L | L |
| 2 | L | 0 | L. |

Die beiden Schalterstellungen für beide Schalter werden mit der Symbolfrequenz 1/T synchron gesteuert. Vor jeder Schalterumstellung wird der bis dahin jeweils errechnete Koeffizientensatz zwischengespeichert, solange bis der nächste Koeffizientensatz errechnet ist. Dann werden beide Koeffizientensätze $K_I$ 51, $K_{IQ}$ 71 im Prozessor I zum neuen Koeffizientensatz $K_I$ 121 und beide Koeffizientensätze $K_{QI}$ 91, $K_Q$ 111 im Prozessor Q zum neuen Koeffizientensatz $K_2$ 131 wie in Fig. 1 beschrieben addiert.

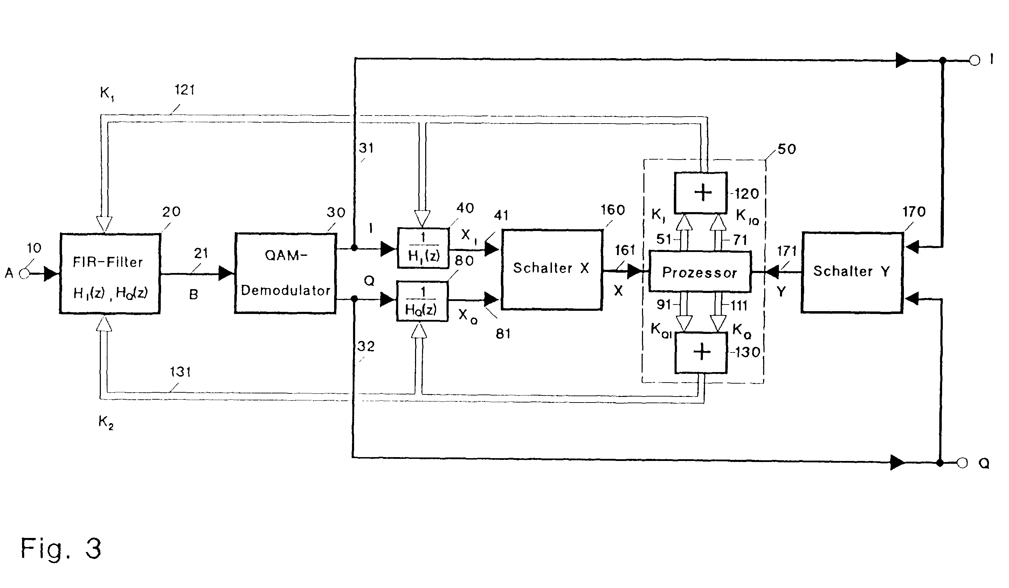

Fig. 3 zeigt eine Anordnung, bestehend aus einem nicht-rekursiven FIR-Filter 20 mit den beiden Teilübertragungsfunktionen $H_I(z)$ und $H_Q(z)$, einem QAM-Demodulator 30, einer Schaltung 40 zur Umwandlung des Datenstroms I mit der inversen Filterübertragungsfunktion $1/H_I(z)$, einer Schaltung 80 zur Umwandlung des Datenstroms Q mit der inversen Filterübertragungsfunktion $1/H_Q(z)$, einem Prozessor 50, einem Schalter X 160 zum Durchschalten der Ausgangssignale $X_I$ 41 und $X_Q$ 81 der beiden Umwandlungsschaltungen 40 und 80 auf einen ersten Eingang des Prozessors 50, einem Schalter Y 170 zum Durchschalten der Ausgangssignale I 31 und Q 32 der Anordnung. Die Anordnung von Fig. 3 ist gegenüber Fig. 2 weiter vereinfacht. Das Ausgangssignal 161 des Schalters X 160 ist das zweite Eingangssignal des Prozessors 50. Der Unterschied von Fig. 3 zu Fig. 1 besteht in einer weiteren Vereinfachung derart, daß die Addierschaltungen 120 und 130 von Fig. 1 entfallen und die Koeffizientensätze in gleicher Weise schon im Prozessor 50 aufeinander addiert werden. Nach außen hin verhält sich Anordnung von Fig. 3 bezüglich der Signale A 10, I 31 und Q 32 genauso wie die Anordnung von Fig. 1. Desweiteren wird als weitere Vereinfachung gegenüber Fig. 2 nur ein Prozessor 50, anstatt der in Fig. 1 notwendigen vier Prozessoren I, IQ, QI und Q benötigt, bei ebenso nur zwei vorgeschalteten Schaltungen 40 und 80 zur Umwandlung des Datenstromes. Der Prozessor 50 dieser Fig. 3 arbeitet im Zeitmultiplex den jeweiligen Iterationsalgorithmus für die unterschiedlichen Eingangssignale X 161 und Y 171 ab. Zusätzlich gegenüber Fig. 1 sind in Fig. 3 ein Schalter X 160 und ein Schalter Y 170 notwenig. Die Schaltmatrix für den Schalter X 160 kann zum Beispiel lauten:

| Schalterstellung | XI | XQ | X |
|---|---|---|---|
| 1 | L | 0 | L |
| 2 | L | 0 | L |
| 3 | 0 | L | L |
| 4 | 0 | L | L. |

Die Schaltmatrix für den Schalter Y 170 kann zum Beispiel lauten:

| Schalterstellung | I | Q | Y |
|---|---|---|---|
| 1 | L | 0 | L |
| 2 | 0 | L | L |
| 3 | 0 | L | L |
| 4 | L | 0 | L. |

Die vier Schalterstellungen für beide Schalter werden mit der Symbolfrequenz 1/T synchron gesteuert. Vor jeder Schalterumstellung wird der bis dahin jeweils errechnete Koeffizientensatz zwischengespeichert bis der nächste Koeffizientensatz errechnet ist. Dann werden beide Koeffizientensätze $K_I$ 51, $K_{IQ}$ 71 im Prozessor zum neuen Koeffizientensatz $K_I$ 121 und die beiden nächsten Koeffizientensätze $K_{QI}$ 91, $K_Q$ 111 im Prozessor Q zum neuen Koeffizientensatz $K_2$ 131 wie in Fig. 1 beschrieben addiert. Beide neuen Koeffizientensätze K1 und $K_2$ werden zum FIR-Filter 20 geführt.

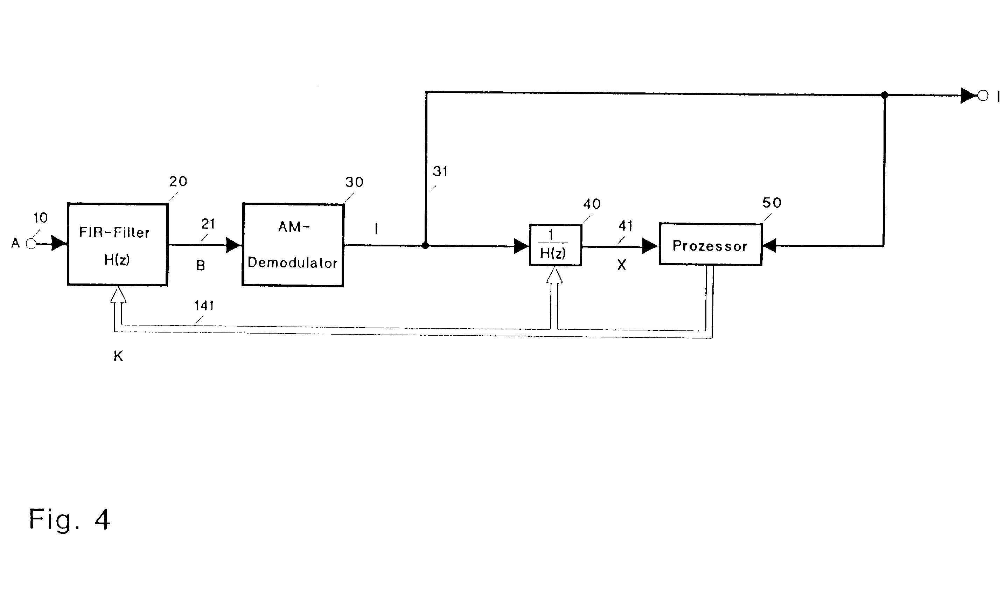

Fig. 4 zeigt eine Anordnung, bestehend aus einem nicht-rekursiven FIR-Filter 20 mit der Übertragungsfunktion H(z), einem Amplitudendemodulator 30, einer Schaltung 40 zur Umwandlung des Datenstroms I mit der inversen Filterübertragungsfunktion 1/H(z), einem Prozessor 50. Die Anordnung von Fig. 4 ist gegenüber Fig. 1, Fig. 2 und Fig. 3 weiter vereinfacht und ein rein amplitudenmodulierter Sonderfall für das Signal Q gleich null. Es kann auch die andere Komponente Q gleich null sein, in diesem Fall heißt der Datenstrom dann Q 31. Das Ausgangssignal 41 der Schaltung 40 zur Umwandlung ist ein Eingang des Prozessors 50. Das zweite Eingangssignal des Prozessors ist das Ausgangssignal 31 der Anordnung. Der Prozessor dieser Fig. 4 arbeitet nicht im Zeitmultiplex, sondern nur den Iterationsalgorithmus für die beiden Eingangssignale X 41 und 131. Deshalb ergibt sich auch nur ein Koeffizientensatz K 141, welcher zur Schaltung 40 und zum nicht-rekursiven FIR-Filter 20 geführt wird. Da die Q-Komponente, bzw. die Q-Komponenten, des Ausgangssignals der Anordnung gleich null ist/sind, werden im nicht-rekursiven FIR-Filter 20 von Fig. 5 auch nur die I-Koeffizienten $a_{01}$, $a_{11}$, $a_{21}$, $a_{31}$, ..., $a_{nl}$ gestellt, alle anderen Koeffizienten $a_{02}$, $a_{12}$, $a_{22}$, $a_{32}$,.., $a_{n2}$ sind ständig null. Dies ist gleichbedeutend mit einem nicht-rekursiven FIR-Filter, weiches von Koeffizient zu Koeffizient nur eine Zeitverzögerung von T aufweist.

Die Anordnung von Fig. 5 umfaßt $2 \cdot (n + 1)$ gleichartige Multiplizierschaltungen 30 und $2 \cdot (n + 1)$ gleichartige Verzögerungsschaltungen 20 und eine Addierschaltung 40. Das Eingangssignal A 10 wird in $2 \cdot (n + 1)$ Teilsignale aufgespalten, jedes Teilsignal wird jeweils über eine Verzögerungschaltung 20 und eine Multiplizierschaltung 30 geführt. Alle $2 \cdot (n + 1)$ Teilsignale werden in der Addierschaltung 40 gemeinsam addiert. Mit dem Koeffizientensatz $K_I$ 60 werden die Koeffizienten $a_{01}$, $a_{11}$, $a_{21}$, $a_{31}$, ..., $a_{n1}$ als Multiplikatoren der Anordnung eingestellt. Mit dem Koeffizientensatz $K_2$ 70 werden die Koeffizienten $a_{02}$, $a_{12}$, $a_{22}$, $a_{32}$, ..., $a_{n2}$ als Multiplikatoren der Anordnung eingestellt. Das Ausgangssignal B 50 der Anordnung entsteht durch um die Multiplikatoren 30 gewichtete und um die Zeitkonstante T/2 20 verzögerte Addition der $2 \cdot (n + 1)$ Teilsignale. Die Zeitkonstante T entpricht dem zeitlichen Abstand zwischen dem Auftreten unmittelbar benachbarter Symbole im Basisband. Für den Anwender arbeitet das FIR-Filter von Fig. 5 nach außen hin mit der doppelten Frequenz $2 \cdot f_T$ gegenüber der Taktfrequenz $f_T = 1/T$ im Basisband. Dies entspricht einer Überabtastung um den Faktor 2. Das Ausgangssignal B 50 der Anordnung ist somit zur Zeit t:

$$B(t) = a_{01} A(t) + a_{02} A(t-T/2) + a_{11} A(t-T) +$$
$$a_{12} A(t-3T/2) + ... + a_{n2} A(t-nT).$$

Für den Sonderfall der Amplitudenmodulation von Fig. 4 sind die Koeffizienten $a_{02}$, $a_{12}$, $a_{22}$, $a_{32}$, ..., $a_{n2}$ alle identisch null, damit ist der zeitliche Abstand zwischen den Teilsignalen T anstatt T/2 bei Quadraturamplitudenmodulation.

## Patentansprüche

1. Verfahren zum Entzerren von zwei Datenströmen (I, Q), die in Quadraturlage zueinander auf einen gemeinsamen Träger moduliert sind, mit einem steuerbaren, nicht-rekursivem Filter (20), welches im Signalweg vor einem Demodulator (30) für die zwei Datenströme (I, Q) angeordnet ist und dessen Koeffizienten ($K_1$, 121; $K_2$, 131) aus zwei Koeffizienten-Sätzen mit getrennter Wirkung für jeden der beiden Datenströme mittels der demodulierten Datenströme gesteuert werden, gekennzeichnet durch die folgenden Schritte:

- der erste Koeffizienten-Satz (K1, 121) für eine erste zeitliche Lage k+1 wird erzeugt durch Verknüpfung von Koeffizienten eines KI-Koeffizientensatzes (51) und eines KIQ-Koeffizientensatzes (71), wobei
der KI-Koeffizientensatz (51) aus dem ersten demodulierten Datenstrom (I, 31) und einem Faltungsprodukt (41) abgeleitet wird, welches aus dem ersten demodulierten Datenstrom (I, 31) und dem ersten Koeffizienten-Satz (K1, 121) für eine zweite zeitliche Lage k, die vor der ersten zeitlichen Lage liegt, gebildet wird und der KIQ-Koeffizientensatz (71) aus dem zweiten demodulierten Datenstrom (Q, 32) und einem Faltungsprodukt (41, 61) abgeleitet wird, welches aus dem ersten demodulierten Datenstrom (I, 31) und dem ersten Koeffizientensatz (K1, 121) für die zeitliche Lage k gebildet wird;

- der zweite Koeffizienten-Satz (K2, 131) für die zeitliche Lage k+1 wird erzeugt durch Verknüpfung von Koeffizienten eines KQI-Koeffizientensatzes (91) und eines KQ-Koeffizientensatzes (111), wobei
der KQI-Koeffizientensatz (91) aus dem ersten demodulierten Datenstrom (I, 31) und einem Faltungsprodukt (81) abgeleitet wird, welches aus dem zweiten demodulierten Datenstrom (Q, 32) und dem zweiten Koeffizienten-Satz (K2, 131) für die zeitliche Lage k gebildet wird und der KQ-Koeffizientensatz (111) aus dem zweiten demodulierten Datenstrom (Q, 32) und einem Faltungsprodukt (81, 101) abgeleitet wird, welches aus dem zweiten demodulierten Datenstrom (Q, 32) und dem zweiten Koeffizientensatz (K2, 131) für die zeitliche Lage k gebildet wird;

- zur Bildung der Faltungsprodukt-Ergebnisse wird der zugehörige demodulierte Datenstrom (I, 31; Q, 32) mit einer zu der jeweiligen Übertragungs-Funktion ($H_I(z)$, $H_Q(z)$) des Filters (20) entsprechend inversen Filterübertragungs-Funktion gefiltert (40, 60, 80, 100).

2. Verfahren zum Entzerren eines Datenstroms (I), der auf einen Träger moduliert ist, mit einem steuerbaren, nicht-rekursivem Filter (20), welches im Signalweg vor einem Demodulator (30) für den Datenstrom (I) angeordnet ist und dessen Koeffizienten (K, 141) mittels des demodulierten Datenstroms gesteuert werden, dadurch **gekennzeichnet,** daß der Koeffizienten-Satz (K, 141) für eine erste zeitliche Lage k+1 aus dem demodulierten Datenstrom (I, 31) und einem Faltungsprodukt (X, 41) abgeleitet wird, welches aus dem demodulierten Datenstrom (I, 31) und dem Koeffizienten-Satz (K, 141) für eine zweite zeitliche Lage k, die vor der ersten zeitlichen Lage liegt, gebildet wird, wobei zur Bildung des Faltungsprodukt-Ergebnisses der demodulierte Datenstrom (I, 31) mit einer zu der Übertragungs-Funktion (H(z)) des Filters (20) entsprechend inversen Filterübertragungs-Funktion gefiltert (40) wird.

3.  Vorrichtung zum Entzerren von zwei Datenströmen (I, Q), die in Quadraturlage zueinander auf einen gemeinsamen Träger moduliert sind, mit einem steuerbaren, nicht-rekursivem Filter (20), welches im Signalweg vor einem Demodulator (30) für die zwei Datenströme (I, Q) angeordnet ist und dessen Koeffizienten (K$_1$, 121; K$_2$, 131) aus zwei Koeffizienten-Sätzen mit getrennter Wirkung für jeden der beiden Datenströme mittels der demodulierten Datenströme gesteuert werden, gekennzeichnet durch:

    -   erste Verknüpfungsmittel (120), die den ersten Koeffizienten-Satz (K1, 121) für eine erste zeitliche Lage k+1 durch Verknüpfung von Koeffizienten eines KI-Koeffizientensatzes (51) und eines KIQ-Koeffizientensatzes (71) erzeugen, wobei ein Prozessor (50, 70, 90, 110) den KI-Koeffizientensatz (51) aus dem ersten demodulierten Datenstrom (I, 31) und einem Faltungsprodukt (41) ableitet, welches aus dem ersten demodulierten Datenstrom (I, 31) und dem ersten Koeffizienten-Satz (K1, 121) für eine zweite zeitliche Lage k, die vor der ersten zeitlichen Lage liegt, gebildet ist und den KIQ-Koeffizientensatz (71) aus dem zweiten demodulierten Datenstrom (Q, 32) und einem Faltungsprodukt (41, 61) ableitet, welches aus dem ersten demodulierten Datenstrom (I, 31) und dem ersten Koeffizientensatz (K1, 121) für die zeitliche Lage k gebildet ist;
    -   zweite Verknüpfungsmittel (130), die den zweiten Koeffizienten-Satz (K2, 131) für die zeitliche Lage k+1 durch Verknüpfung von Koeffizienten eines KQI-Koeffizientensatzes (91) und eines KQ-Koeffizientensatzes (111) erzeugen, wobei ein Prozessors (50, 70, 90, 110) den KQI-Koeffizientensatz (91) aus dem ersten demodulierten Datenstrom (I, 31) und einem Faltungsprodukt (81) ableitet, welches aus dem zweiten demodulierten Datenstrom (Q, 32) und dem zweiten Koeffizienten-Satz (K2, 131) für die zeitliche Lage k gebildet ist und

den KQ-Koeffizientensatz (111) aus dem zweiten demodulierten Datenstrom (Q, 32) und einem Faltungsprodukt (81, 101) ableitet, welches aus dem zweiten demodulierten Datenstrom (Q, 32) und dem zweiten Koeffizientensatz (K2, 131) für die zeitliche Lage k gebildet ist;

-   nach dem Demodulator (30) angeordnete Filtermittel (40, 60, 80, 100), die zur Bildung der Faltungsprodukt-Ergebnisse den zugehörigen demodulierten Datenstrom (I, 31; Q, 32) mit einer zu der jeweiligen Übertragungs-Funktion (H$_I$(z), H$_Q$(z)) des Filters (20) entsprechend inversen Filterübertragungs-Funktion filtern.

4.  Vorrichtung zum Entzerren eines Datenstroms (I), der auf einen Träger moduliert ist, mit einem steuerbaren, nicht-rekursivem Filter (20), welches im Signalweg vor einem Demodulator (30) für den Datenstrom (I) angeordnet ist und dessen Koeffizienten (K, 141) mittels des demodulier- ten Datenstroms gesteuert werden, **gekennzeichnet** durch einen Prozessor (50), der den Koeffizienten-Satz (K, 141) für eine erste zeitliche Lage k+1 ableitet aus dem demodulierten Datenstrom (I, 31) und einem Faltungsprodukt (X, 41), welches aus dem demodulierten Datenstrom (I, 31) und dem Koeffizienten-Satz (K, 141) für eine zweite zeitliche Lage k, die vor der ersten zeitlichen Lage liegt, gebildet ist, wobei zur Bildung des Faltungsprodukt-Ergebnisses ein nach dem Demodulator (30) angeordnetes Filter (40) den demodulierten Datenstrom (I, 31) mit einer zu der Übertragungs-Funktion (H(z)) des Filters (20) entsprechend inversen Filterübertragungs-Funktion filtert.

**Claims**

1.  Method for equalizing two data streams (I, Q) which are modulated in quadrature position relative to one another on a common carrier, having a controllable non-recursive filter (20) which is arranged in the signal path upstream of a demodulator (30) for the two data streams (I, Q) and whose coefficients (K$_1$, 121; K$_2$, 131) from two coefficient sets which act separately for each of the two data streams are controlled by means of demodulated data streams, characterized by the following steps:

    -   the first coefficient set (K1, 121) for a first temporal position k+1 is generated by combining coefficients of a KI coefficient set (51) and of a KIQ coefficient set (71), it being the case that the KI coefficient set (51) is derived from the first demodulated data stream (I, 31) and a convolution product (41) which is formed from the first demodulated data stream (I, 31) and the first coefficient set (K1, 121) for a second temporal position k, which is situated upstream of the first temporal position, and the KIQ coefficient set (71) is derived from the second demodulated data stream (Q, 32) and a convolution product (41, 61) which is formed from the first demodulated data stream (I, 31) and the first coefficient set (K1, 121) for the temporal position k;

- the second coefficient set (K2, 131) for the temporal position k+1 is generated by combining coefficients of a KQI coefficient set (91) and of a KQ coefficient set (111), it being the case that the KQI coefficient set (91) is derived from the first demodulated data stream (I, 31) and a convolution product (81) which is formed from the second demodulated data stream (Q, 32) and the second coefficient set (K2, 131) for the temporal position k, and the KQ coefficient set (111) is derived from the second demodulated data stream (Q, 32) and a convolution product (81, 101) which is formed from the second demodulated data stream (Q, 32) and the second coefficient set (K2, 131) for the temporal position k; and

- for the purpose of forming the convolution product results, the associated demodulated data stream (I, 31; Q, 32) is filtered by means of a filter transfer function (40, 60, 80, 100) which is appropriately inverse to the respective transfer function ($H_I(z)$, $H_Q(z)$) of the filter (20).

2. Method for equalizing a data stream (I), which is modulated onto a carrier, having a controllable non-recursive filter (20) which is arranged in the signal path upstream of a demodulator (30) for the data stream (I) and whose coefficients (K, 141) are controlled by means of the demodulated data stream, characterized in that the coefficient set (K1, 141) is derived for a first temporal position k+1 from the demodulated data stream (I, 31) and a convolution product (X, 41) which is formed from the demodulated data stream (I, 31) and the coefficient set (K, 141) for a second temporal position k, which is situated upstream of the first temporal position, it being the case that for the purpose of forming the convolution product result, the demodulated data stream (I, 31) is filtered (40) by means of a filter transfer function which is appropriately inverse to the transfer function (H(z)) of the filter (20).

3. Device for equalizing two data streams (I, Q) which are modulated in quadrature position relative to one another on a common carrier, having a controllable, non-recursive filter (20) which is arranged in the signal path upstream of a demodulator (30) for the two data streams (I, Q) and whose coefficients ($K_1$, 121; $K_2$, 131) from two coefficient sets which act separately for each of the two data streams are controlled by means of demodulated data streams, characterized by:

- first combining means (120) which generate the first coefficient set (K1, 121) for a first temporal position k+1 by combining coefficients of a KI coefficient set (51) and of a KIQ coefficient set (71), it being the case that a processor (50, 70, 90, 110) derives the KI coefficient set (51) from the first demodulated data stream (I, 31) and a convolution product (41) which is formed from the first demodulated data stream (I, 31) and the first coefficient set (K1, 121) for a second temporal position k, which is situated upstream of the first temporal position, and derives the KIQ coefficient set (71) from the second demodulated data stream (Q, 32) and a convolution product (41, 61) which is formed from the first demodulated data stream (I, 31) and the first coefficient set (K1, 121) for the temporal position k;

- second combining means (130) which generate the second coefficient set (K2, 131) for the temporal position k+1 by combining coefficients of a KQI coefficient set (91) and a KQ coefficient set (111), it being the case that a processor (50, 70, 90, 110) derives the KQI coefficient set (91) from the first demodulated data stream (I, 31) and a convolution product (81) which is formed from the second demodulated data stream (Q, 32) and the second coefficient set (K2, 131) for the temporal position k, and derives the KQ coefficient set (111) from the second demodulated data stream (Q, 32) and a convolution product (81, 101) which is formed from the second demodulated data stream (Q, 32) and the second coefficient set (K2, 131) for the temporal position k; and

- filter means (40, 60, 80, 100) which are arranged downstream of the demodulator (30) and, for the purpose of forming the convolution product results, filter the associated demodulated data stream (I, 31; Q, 32) by means of a filter transfer function which is appropriately inverse to the respective transfer function ($H_I(z)$, $H_Q(z)$) of the filter (20).

4. Method for equalizing a data stream (I) which is modulated onto a carrier, having a controllable non-recursive filter (20) which is arranged in the signal path upstream of a demodulator (30) for the data stream (I) and whose coefficients (K, 141) are controlled by means of the demodulated data stream, characterized by a processor (50) which derives the coefficient set (K, 141) for a first temporal position k+1 from the demodulated data stream (I, 31) and a convolution product (X, 41) which is formed from the demodulated data stream (I, 31) and the coefficient set (K, 141) for a second temporal position k, which is situated upstream of the first temporal position, it being the case that for the purpose of forming the convolution product result a filter (40) arranged downstream of the demodulator (30) filters the demodulated data stream (I, 31) by means of a filter transfer function which is appropriately inverse to the transfer function (H(z)) of the filter (20).

## Revendications

1.  Procédé de correction de deux flux de données (I, Q) qui sont modulés en quadrature l'un par rapport à l'autre sur une porteuse commune, avec un filtre non-récursif réglable (20), placé sur le trajet du signal avant un démodulateur (30) pour les deux flux de données (I, Q) et dont les coefficients ($K_1$, 121, $K_2$, 131) provenant de deux jeux de coefficients avec effet séparé pour chacun des deux flux de données sont commandés à l'aide des flux de données démodulés, **caractérisé par** les étapes suivantes :

    -   le premier jeu de coefficients ($K_1$, 121) pour une première situation temporelle k+1 est généré par la combinaison de coefficients d'un jeu de coefficients KI (51) et d'un jeu de coefficients KIQ (71) où le jeu de coefficients KI (51) est obtenu à partir du premier flux de données démodulé (I, 31) et d'un produit de convolution (41), lequel est établi à partir du premier flux de données démodulé (I, 31) et du premier jeu de coefficients ($K_1$, 121) pour une deuxième situation temporelle k située avant la première situation temporelle et le jeu de coefficients KIQ (71) est obtenu à partir du deuxième flux de données démodulé (Q, 32) et d'un produit de convolution (41, 61), lequel est établi à partir du premier flux de données démodulé (I, 31) et du premier jeu de coefficients ($K_1$, 121) pour la situation temporelle k,
    -   le deuxième jeu de coefficients ($K_2$, 131) pour la situation temporelle k+1 est généré par la combinaison de coefficients d'un jeu de coefficients KQI (91) et d'un jeu de coefficients KQ (111) où le jeu de coefficients KQI (91) est obtenu à partir du premier flux de données démodulé (I, 31) et d'un produit de convolution (81), lequel est établi à partir du deuxième flux de données démodulé (Q, 32) et du deuxième jeu de coefficients ($K_2$, 131) pour la situation temporelle k et le jeu de coefficients KQ (111) est obtenu à partir du deuxième flux de données démodulé (Q, 32) et d'un produit de convolution (81), lequel est établi à partir du deuxième flux de données démodulé (Q, 32) et du deuxième jeu de coefficients ($K_2$, 131) pour la situation temporelle k,
    -   pour l'obtention des résultats du produit de convolution, le flux de données démodulé correspondant (I, 31, Q, 32) est filtré avec une fonction de transmission à filtre inverse (40, 60, 80, 100) correspondant à la fonction de transmission concernée ($H_I(z)$, $H_Q(z)$) du filtre (20).

2.  Procédé de correction d'un flux de données (I) modulé sur une porteuse, avec un filtre non-récursif réglable (20), placé sur le trajet du signal avant un démodulateur (30) pour le flux de données (I) et dont les coefficients (K, 141) sont commandés à l'aide du flux de données démodulé, **caractérisé en ce que** le jeu de coefficients (K, 141) pour une première situation temporelle k+1 est obtenu à partir du flux de données démodulé (I, 31) et d'un produit de convolution (X, 41), lequel est établi à partir du flux de données démodulé (I, 31) et du jeu de coefficients (K, 141) pour une deuxième situation temporelle k située avant la première situation temporelle où, pour l'obtention des résultats du produit de convolution, le flux de données démodulé (I, 31) est filtré avec une fonction de transmission à filtre inverse (40) correspondant à la fonction de transmission (H(z)) du filtre (20).

3.  Dispositif de correction de deux flux de données (I, Q) qui sont modulés en quadrature l'un par rapport à l'autre sur une porteuse commune, avec un filtre non-récursif réglable (20), placé sur le trajet du signal avant un démodulateur (30) pour les deux flux de données (I, Q) et dont les coefficients ($K_1$, 121, $K_2$, 131) provenant de deux jeux de coefficients avec effet séparé pour chacun des deux flux de données sont commandés à l'aide des flux de données démodulés, **caractérisé par:**

    -   des premiers moyens de combinaison (120) qui génèrent le premier jeu de coefficients ($K_1$, 121) pour une première situation temporelle k+1 par la combinaison de coefficients d'un jeu de coefficients KI (51) et d'un jeu de coefficients KIQ (71) où le jeu de coefficients KI (51) est calculé par un processeur (50, 70, 90, 110) à partir du premier flux de données démodulé (I, 31) et d'un produit de convolution (41), lequel est établi à partir du premier flux de données démodulé (I, 31) et du premier jeu de coefficients ($K_1$, 121) pour une deuxième situation temporelle k située avant la première situation temporelle et le jeu de coefficients KIQ (71) est obtenu à partir du deuxième flux de données démodulé (Q, 32) et d'un produit de convolution (41, 61), lequel est établi à partir du premier flux de données démodulé (I, 31) et du premier jeu de coefficients ($K_1$, 121) pour la situation temporelle k,
    -   des deuxièmes moyens de combinaison (130) qui génèrent le deuxième jeu de coefficients ($K_2$, 131) pour la situation temporelle k+1 par la combinaison de coefficients d'un jeu de coefficients KQI (91) et d'un jeu de coefficients KQ (111) où le jeu de coefficients KQI (91) est calculé par un processeur (50, 70, 90, 110) à partir du premier flux de données démodulé (I, 31) et d'un produit de convolution (81), lequel est établi à partir du deuxième flux de données démodulé (Q, 32) et du deuxième jeu de coefficients ($K_2$, 131) pour la situation temporelle k et le jeu de coefficients KQ (111) est obtenu à partir du deuxième flux de données démodulé (Q, 32) et d'un produit de convolution (81), lequel est établi à partir du deuxième flux de données démodulé (Q, 32) et du deuxième jeu de coefficients ($K_2$, 131) pour la situation temporelle k,

- des moyens de filtrage (40, 60, 80, 100) situés en aval du démodulateur (30) qui, pour l'obtention des résultats du produit de convolution, filtrent le flux de données démodulé correspondant (I, 31, Q, 32) avec une fonction de transmission à filtre inverse correspondant à la fonction de transmission concernée ($H_I(z)$, $H_Q(z)$) du filtre (20).

4. Dispositif de correction d'un flux de données (I) modulé sur une porteuse, avec un filtre non-récursif réglable (20), placé sur le trajet du signal avant un démodulateur (30) pour le flux de données (I) et dont les coefficients (K, 141) sont commandés à l'aide du flux de données démodulés, **caractérisé par** un processeur (50) qui calcule le jeu de coefficients (K, 141) pour une première situation temporelle k+1 à partir du flux de données démodulé (I, 31) et d'un produit de convolution (X, 41), lequel est établi à partir du flux de données démodulé (I, 31) et du jeu de coefficients (K, 141) pour une deuxième situation temporelle k située avant la première situation temporelle où, pour l'obtention des résultats du produit de convolution, un filtre (40) situé en aval du démodulateur (30) filtre le flux de données démodulé (I, 31) avec une fonction de transmission à filtre inverse correspondant à la fonction de transmission (H(z)) du filtre (20).

Fig. 1

Fig. 2

Fig. 3

Fig. 4

Fig. 5